# EUROPÄISCHE PATENTSCHRIFT

(11) **EP 0 774 670 B1**
(45) Veröffentlichungstag und Bekanntmachung des Hinweises auf die Patenterteilung: **02.05.2002**
(21) Anmeldenummer: 96117428.1
(22) Anmeldetag: 30.10.1996
(51) Int. Cl.: G01R 33/38

(54) **Magnetanordnung für ein diagnostisches Magnetresonanzgerät**
Magnet assembly for a diagnostic magnetic resonance apparatus
Dispositif d'aimants pour un appareil de diagnostique par résonance magnétique

(30) Priorität: 16.11.1995 DE 19542812
(43) Veröffentlichungstag der Anmeldung: 21.05.1997
(73) Patentinhaber: SIEMENS AKTIENGESELLSCHAFT, 80333 München (DE)
(72) Erfinder: Frese, Georg, 91074 Herzogenaurach (DE); Sellers, Michael, 91054 Erlangen (DE)

(56) Entgegenhaltungen:
- EP-A- 0 186 998
- EP-A- 0 424 808
- US-A- 5 410 287

## Beschreibung

Die Erfindung betrifft eine Magnetanordnung für ein diagnostisches Magnetresonanzgerät mit einer Elektromagnetanordnung zum Erzeugen eines im wesentlichen homogenen, entlang einer Achse ausgerichteten Magnetfeldes in einem Abbildungsvolumen, wobei in Bezug zur Achse des Magnetfeldes ein transversaler Zugang zum Abbildungsvolumen ausgebildet ist.

Fast jeder Hersteller von diagnostischen Magnetresonanzgeräten bietet heute offene Systeme an. Dies sind in der Regel Niederfeldsysteme mit zwei Polschuhen, die ein zeitlich konstantes Hauptmagnetfeld erzeugen, dessen homogener Feldbereich das Abbildungsvolumen bestimmt. Die Systeme besitzen einen Patientenzugang und bieten für einen Arzt oder Untersucher eine zusätzliche Zugangsmöglichkeit zum Abbildungsvolumen. Die Polschuhe sind mit einer Flußrückführung, die H-förmig (d.h. symmetrisch) oder C-förmig sein kann, miteinander verbunden. Als magnetische Antriebe werden Spulen oder Permanentmagnete verwendet, die sich in den Polschuhen selbst oder in der Flußrückführung befinden.

Eine Magnetanordnung der eingangs genannten Art ist in der US-PS 5 345 208 beschrieben. Gegenüberliegend angeordnete Polschuhe sind über eine C-förmige magnetische Rückführung miteinander verbunden. Eine Elektromagnet-Anordnung in Form einer supraleitenden Spule befindet sich in der Rückführung.

Eine Magnetanordnung der eingangs genannten Art ist auch aus der US-PS 4 902 995 bekannt. Das Hauptmagnetfeld wird dort von zwei gegenüberliegend angeordneten und gleich ausgebildeten supraleitenden Spulen erzeugt.

Aus der US-PS 5,410,287 ist eine offene Magnetanordnung mit supraleitenden Magneten bekannt. Die Magnetanordnung umfasst zwei gleich ausgebildete und koaxial und in Richtung der Magnetfeldachse beabstandet angeordnete Spulenanordnungen. Die Spulenanordnungen sind jeweils von eigenen toroidförmigen Gehäusen umgeben. Die Spulenanordnungen sind so dimensioniert, dass bei einem entsprechenden Stromfluss zentral auf der Magnetachse zwischen den beiden Gehäusen ein homogenes Magnetfeld erzeugt wird, der zur Bildgebung mittels magnetischer Resonanz verwendet wird. Dieser homogene Bereich besitzt axiale Zugänge über die zentralen Öffnungen der beiden Gehäuse und transversale Zugänge zwischen den beiden Gehäusen.

Der Erfindung liegt nun die Aufgabe zugrunde, eine offene Magnetanordnung anzugeben, mit der in einem Abbildungsvolumen eine hohe Magnetfeldstärke erzeugt werden kann.

Die Aufgabe wird dadurch gelöst, daß die Elektromagnetanordnung quer zur Achse gegenüberliegend beabstandet angeordnete erste und zweite Windungen umfaßt, so daß zwischen den ersten und zweiten Windungen ein axialer Zugang in Richtung der Achse des Magnetfeldes zum Abbildungsvolumen ausgebildet ist. Durch die Aufteilung der Elektromagnetanordnung in zwei gegenüberliegend angeordnete Windungen kann nun auch bei einem offenen System eine bisher meist nur mit geschlossenen Systemen erreichbare hohe Feldstärke im Abbildungsvolumen erzeugt werden.

Eine vorteilhafte Ausgestaltung zeichnet sich dadurch aus, daß die ersten und zweiten Windungen jeweils erste und zweite Windungsabschnitte umfassen, die in einer Umfangsrichtung des Abbildungsvolumens senkrecht zur Achse des Magnetfeldes ausgerichtet sind, und daß die ersten Windungsabschnitte näher zum Abbildungsvolumen angeordnet sind als die zweiten Windungsabschnitte. Die näher zum Abbildungsvolumen angeordneten ersten Windungsabschnitte erzeugen im Abbildungsvolumen das entlang der Achse ausgerichtete Nutzfeld. Die zweiten äußeren Windungsabschnitte schirmen das Magnetfeld nach außen zumindest zu einem Teil ab, sodaß das Streufeld ähnlich stark wie bei einer aktiv geschirmten Standard-Magnetanordnung abfällt.

Bei einer weiteren vorteilhaften Ausgestaltung sind die ersten Windungsabschnitte bogenförmig ausgebildet, wobei eine konkave Seite der ersten Windungsabschnitte dem Abbildungsvolumen zugewandt ist. Damit wird zwar der axiale Zugang etwas eingeschränkt, anderseits jedoch das Magnetfeld in transversaler Richtung homogenisiert.

Eine besonders vorteilhafte Ausgestaltung ist dadurch gekennzeichnet, daß die ersten und zweiten Windungen in mehrere gegenüberliegend angeordnete erste bzw. zweite Spulen zusammengefaßt sind. Nimmt die Amperewindungszahl der Spulen vom Zentrum nach außen zu, kann das Magnetfeld in axialer Richtung homogenisiert werden.

Eine weitere besonders vorteilhafte Ausgestaltung zeichnet sich dadurch aus, daß die Windungsabschnitte verschiedener Spulen verschieden lang ausgebildet sind. Damit kann die Größe des homogenen Abbildungsvolumen insbesondere in Achsenrichtung verbessert werden.

Um die Schirmwirkung der Windungsabschnitte am axialen Zugang zu verbessern ist gemäß einer weiteren vorteilhaften Ausgestaltung eine zweite Anzahl von Windungen im wesentlichen auf schräg zur Achse des Magnetfeldes ausgerichteten Flächen angeordnet.

Ebenfalls zur Verbesserung der Homogenität im Bereich des axialen Zugangs ist gemäß einer weiteren, besonders vorteilhaften Ausgestaltung an mindestens einer Stirnseite der ersten und zweiten Windungen mindestens eine kreisringförmige Spule koaxial zur Achse des Magnetfeldes angeordnet. Der seitliche Zugang für den Arzt bleibt erhalten.

Bei einer weiteren vorteilhaften Ausgestaltung sind zur Abstützung und zur Aufnahme der Gewichts- und/oder Lorentzkräfte die ersten und zweiten Windungen über ein außerhalb des Abbildungsvolumens angeordnetes C-förmiges Stativ miteinander verbunden.

In einer alternativen konstruktiven Ausgestaltung sind zur Abstützung die ersten Windungen mit den zweiten Windungen über säulenartige Ständer miteinander verbunden, die beidseits der Zugänge angeordnet sind. Diese Abstützung ist besonders vorteilhaft bei einer Magnetanordnung mit zusätzlichen äußeren kreisringförmigen Spulen.

Zur Felderhöhung sind bei einer weiteren vorteilhaften Ausgestaltung die ersten und zweiten Windungen auf einem ferromagnetischen Träger gewickelt.

Die Erfindung wird im folgenden anhand von sieben Figuren erläutert. Es zeigen:
- FIG 1: in einer perspektivischen Ansicht eine offene Magnetanordnung mit gegenüberliegend angeordneten Spulen,
- FIG 2: eine offene Magnetanordnung mit einem C-förmigen Stativ,
- FIG 3: eine offene Magnetanordnung mit einer säulenartigen Abstützung,
- FIG 4: eine offene Magnetanordnung mit einem optimierten großen Abbildungsvolumen,
- FIG 5: eine Draufsicht auf eine weitere Ausführungsform der Windungen,
- FIG 6: eine Draufsicht auf eine alternative Form der Windungen und
- FIG 7: in einer Schnittdarstellung eine Seitenansicht einer Magnetanordnung mit einer verbesserten Abschirmung im Bereich des axialen Zugangs.

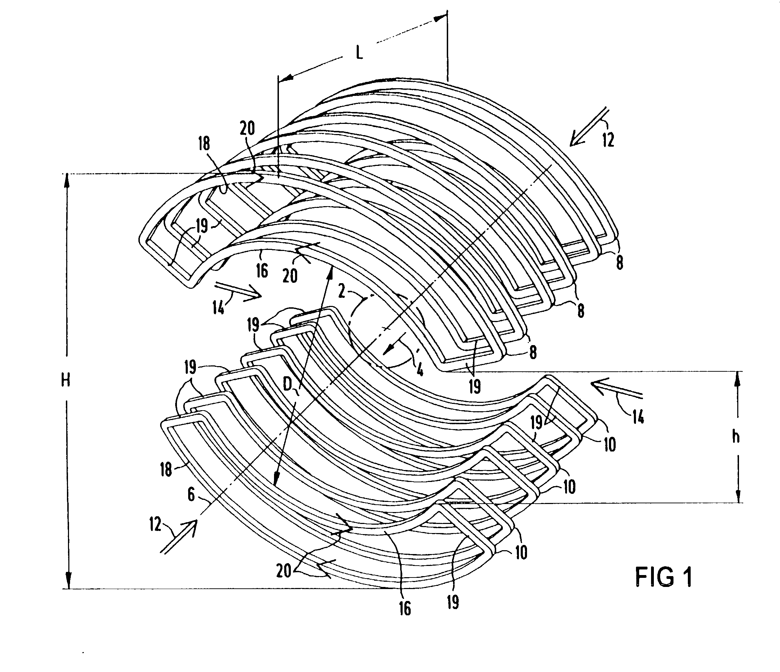

FIG 1 zeigt schematisch eine Magnetanordnung mit Elektromagneten für ein diagnostisches Magnetresonanzgerät. Die Magnetanordnung erzeugt bei einer entsprechenden Erregung mit einem Gleichstrom im Zentrum in einem Abbildungsvolumen 2, ein im wesentlichen homogenes Magnetfeld Bo. Das Magnetfeld Bo, das in FIG 1 durch einen Pfeil 4 symbolisiert ist, ist parallel zu einer Achse 6 ausgerichtet. Die Achse 6 ist auch eine Symmetrieachse der Elektromagnetanordnung.

Die Elektromagnetanordnung umfaßt jeweils sechs erste und zweite Spulen 8 bzw. 10 mit jeweils mehreren hundert ersten bzw. zweiten Windungen, die auf einen Träger (hier nicht dargestellt) gewickelt sind. Der Träger kann als Eisenkern zur Verstärkung des Magnetfeldes Bo im Abbildungsvolumen 2 ausgebildet sein. Die ersten und zweiten Spulen 8 bzw. 10 oder ersten und zweiten Windungen sind quer zur Achse 6 gegenüberliegend angeordnet. Somit ist in Bezug zur Achse 6 ein axialer Zugang 12 und quer dazu ein transversaler Zugang 14 geschaffen. Der axiale Zugang 12 ist zum Einbringen des Patienten zum Abbildungsvolumen 2 ausgebildet, während der transversale Zugang 14 einem Arzt die Möglichkeit gibt, an Patienten während einer Magnetresonanzuntersuchung Eingriffe vorzunehmen.

Die ersten und zweiten Windungen in den ersten und zweiten Spulen 8 bzw. 10 umfassen jeweils erste und zweite Windungsabschnitte 16 bzw. 18, die in einer Umfangsrichtung des Abbildungsvolumens 2 senkrecht zur Achse 6 ausgerichtet sind. Die Windungsabschnitte 16,18 sind jeweils über radiale Leiterstücke 19 miteinander verbunden. Die ersten Windungsabschnitte 16 sind dabei näher zum Abbildungsvolumen 2 angeordnet als die zweiten Windungsabschnitte 18. Die ersten und zweiten Windungsabschnitte 16,18 sind bogenförmig ausgebildet und mit ihrer konkaven Seite dem Abbildungsvolumen 2 zugewandt. Sie überdecken in Umfangsrichtung um die Achse 6 einen Winkel von vorzugsweise ca. 120°.

Die einzelnen Spulen 8,10 sind mit einer Gleichstromversorgung, hier nicht dargestellt, verbunden, wodurch in den einzelnen Windungen ein Strom z.B. in Richtung der in zwei Spulen 8 und 10 eingezeichneten Pfeile 20 fließt. Die übrigen Spulen 8,10 werden in gleicher Richtung vom Strom durchflossen, so daß in allen ersten Windungsabschnitten 16 ein Strom um die Achse 6 entgegen der Uhrzeigerrichtung und in allen zweiten Windungsabschnitten 18 ein Strom in Uhrzeigerrichtung fließt. Der radiale Abstand der ersten und zweiten Windungsabschnitte 16,18 voneinander bestimmt zum einen die Schirmwirkung für das Magnetfeld nach außen und die Stärke des Magnetfeldes Bo im Abbildungsvolumen 2. Aus praktischen Gesichtspunkten sollte der radiale Abstand einerseits so klein wie möglich sein, um die Baugröße in vertretbarem Rahmen zu halten, andererseits jedoch möglichst groß sein, um das Nutzfeld im Abbildungsvolumen 2 nicht zu stark zu reduzieren. Zwischen den beiden gegensätzlichen Forderungen ist ein Kompromiß zu finden.

Die Spulen 8,10 sind bei einer supraleitenden Ausführung in einem hier nicht dargestellten Kryostaten eingebaut. Dann ergeben sich typische Abmessungen der supraleitenden Magnet-Anordnung, mit der im Abbildungsvolumen 2 eine Feldstärke von z.B. 0,7 T erzeugt werden kann:
axiale Länge L = 1,50 m,
Höhe H = 1,80 m,
Innendurchmesser D = 1 m und
Höhe der transversalen Öffnung h = 0,5 m.

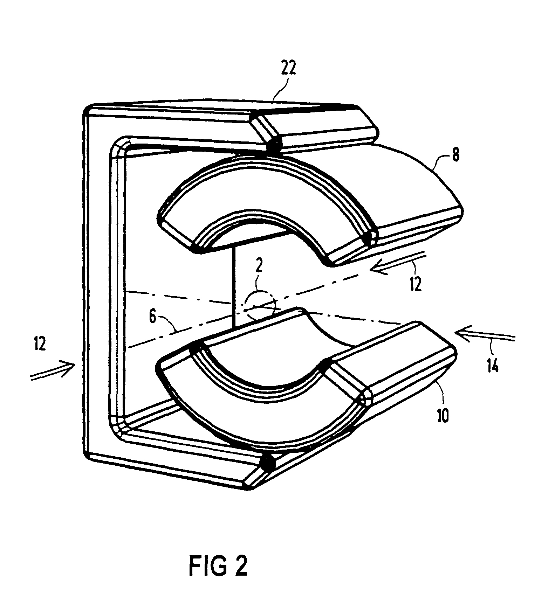

FIG 2 zeigt nun in einer perspektivischen Ansicht eine Konstruktion der Magnetanordnung, bei der die beiden gegenüberliegend angeordneten Spulen über ein C-förmiges Stativ 22 miteinander verbunden sind. Dabei sind die Spulen 8 und 10 jeweils zu gegenüberliegend angeordneten Spulenpakten konstruktiv zusammengefaßt. Das C-förmige Stativ 22 erlaubt einen dreiseitigen Zugang zum Abbildungsvolumen 2. Bei einer supraleitenden Ausführung befinden sich die Spulen 8,10 in einem Kryostaten, wobei das Stativ 22 Teil des Kyrostaten sein kann (hier nicht dargestellt).

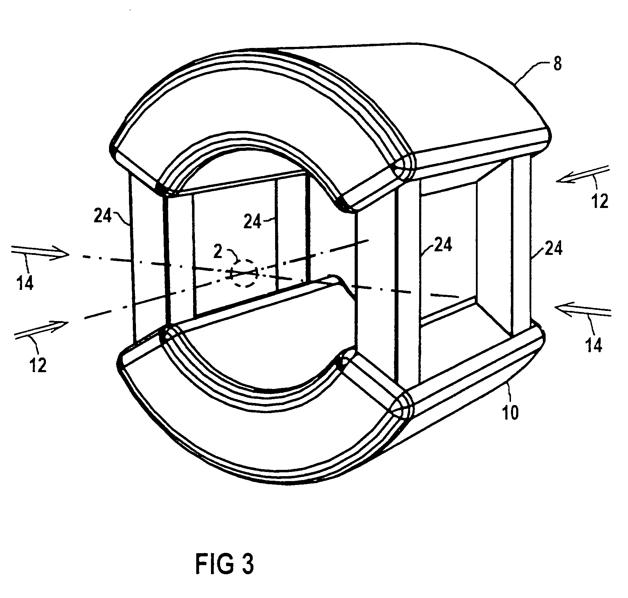

FIG 3 zeigt nun im Unterschied zu FIG 2 eine konstruktive Ausführung mit einem vierseitigen Zugang zum Abbildungsvolumen 2. Die zu jeweils einem Spulenpaket zusammengefaßten ersten und zweiten Spulen 8 bzw. 10 sind hier über an den Enden angeordnete säulenförmige Ständer 24 miteinander verbunden.

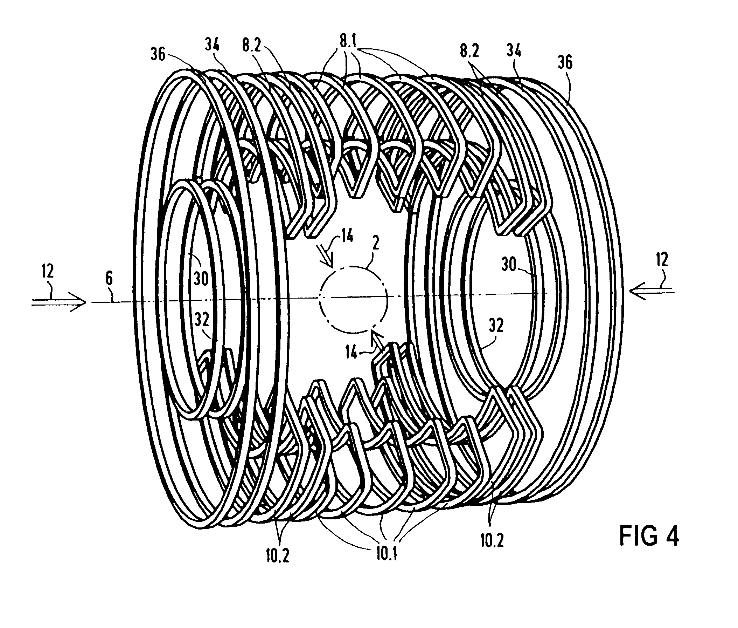

FIG 4 zeigt nun im Prinzip eine Magnetanordnung, bei der insbesondere in axialer Richtung das Abbildungsvolumen 2 vergrößert ist. Dazu sind an den stirnseitigen Enden der ersten und zweiten gegenüberliegend angeordneten Spulen 8 und 10 jeweils zwei kreisringförmige Spulen 30,32 angeordnet. Der Durchmesser der Spulen 30,32 kann geringer als der in FIG 1 eingezeichnete Durchmesser D, der durch die inneren Windungsabschnitte 16 der Spulen 8 und 10 bestimmt ist. Die Spulen 30 und 32 sind ebenfalls mit einer Stromversorgung (hier nicht dargestellt) verbunden, die einen Stromfluß in gleicher Richtung wie auf den ersten Windungsabschnitten 16 der Spulen 8 und 10 erzeugen. Umgeben sind die das Nutzfeld erzeugenden Spulen 30 und 32 von Abschirmspulen 34 und 36.

Zur Vergrößerung des transversalen Zugangs 14 besitzen die inneren fünf Spulen 8.1 und 10.1 im Unterschied zu den beiden sich anschließenden äußeren Spulen 8.2 und 10.2 einen Öffnungswinkel von nur 90°. Für die in FIG 4 dargestellte Magnetanordnung eignet sich besonders die in FIG 3 schon dargestellte säulenförmige Abstützung an den Enden der Spulenpakete.

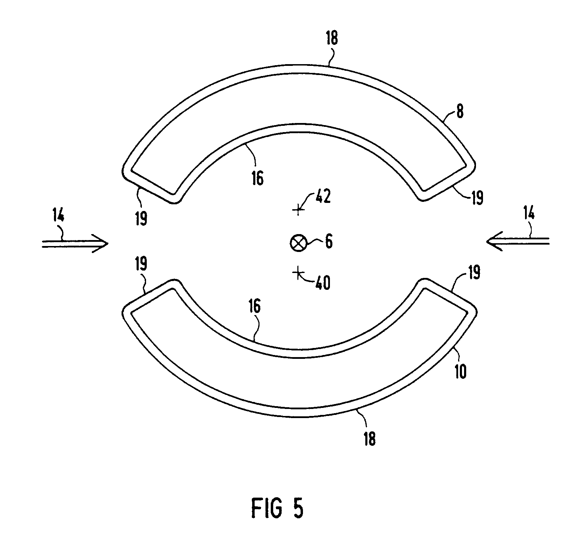

FIG 5 zeigt nun eine Anordnung der ersten und zweiten Spulen 8, 10, wobei der Mittelpunkt der von den Windungen gebildeten Kreisringsegmente nicht auf der Achse 6 sondern quer zum Zugang 14 in vertikaler Richtung verschoben ist. Damit ist die Homogenität des Magnetfeldes Bo in transversaler Richtung, also zu den transversalen Zugängen 14 hin, verbessert. Der Krümmungs-Mittelpunkt der kreisringsegmentförmigen Spule 8 ist mit 40 und der Krümmungs-Mittelpunkt der kreisringsegmentförmigen Spule 10 ist mit 42 gekennzeichnet.

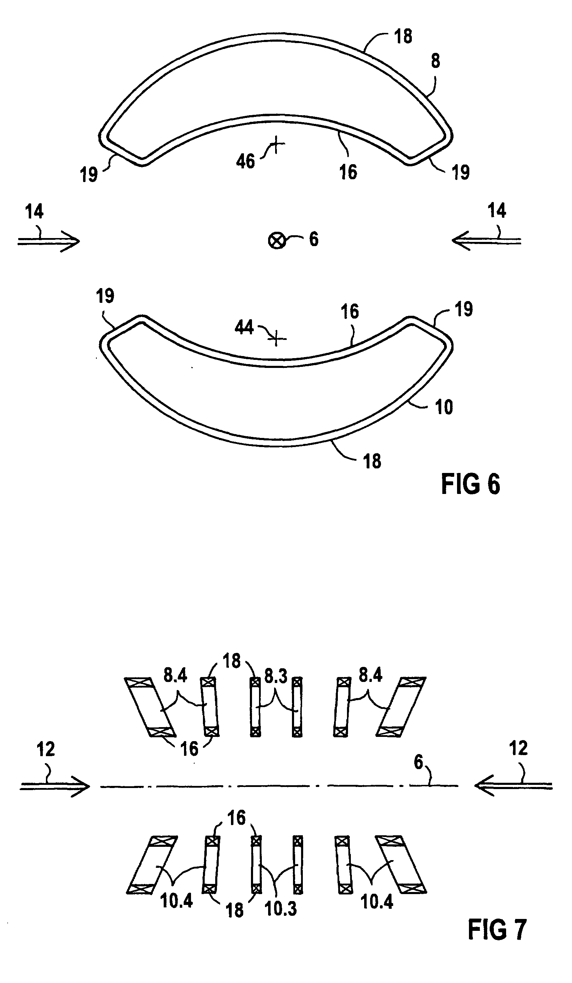

Auch die in FIG 6 dargestellte Windungsform der ersten und zweiten Spulen 8 bzw. 10 verbessert die Homogenität in transversaler Richtung im Untersuchungsraum. Hier sind jedoch nur die Krümmungs-Mittelpunkte der inneren ersten Windungsabschnitte 16 quer zum transversalen Zugang 14 von der Achse 6 versetzt angeordnet. So ist der Krümmungs-Mittelpunkt der ersten windungsabschnitte der oberen Spule 8 mit 44 und der Krümmungs-Mittelpunkt der ersten Windungsabschnitte 16 der unteren Spule 10 mit 46 gekennzeichnet. Der Krümmungs-Mittelpunkt der äußeren zweiten kreisbogenförmigen Windungsabschnitte 18 liegt auf der Achse 6.

FIG 7 zeigt in einer Seitenansicht in einer prinzipiellen Schnittdarstellung eine Magnetanordnung, wobei nur mittlere Spulen 8.3 und 10.3 in senkrecht zur ersten Achse 6 ausgerichteten Ebenen angeordnet sind. Dagegen sind äußere Spulen 8.4 und 10.4 auf schräg zur ersten Achse 6 ausgerichteten Flächen angeordnet. Durch die schräge Ausrichtung wird die Schirmwirkung der Magnetanordnung nach außen an den axialen Zugängen verbessert.

## Patentansprüche

1. Magnetanordnung für ein diagnostisches Magnetresonanzgerät mit einer Elektromagnetanordnung zum Erzeugen eines homogenen, entlang einer Achse (6) ausgerichteten Magnetfeldes im einem Abbildungsvolumen (2), wobei in Bezug zur Achse (6) des Magnetfeldes ein transversaler Zugang (14) zum Abbildungsvolumen (2) ausgebildet ist, **dadurch gekennzeichnet, daß** die Elektromagnetanordnung quer zur Achse (6) des Magnetfeldes gegenüberliegend beabstandet angeordnete erste und zweite Windungen (8 bzw. 10) umfaßt, so daß zwischen den ersten und zweiten Windungen (8,10) ein axialer Zugang (12) in Richtung der Achse (6) des Magnetfeldes zum Abbildungsvolumen (2) ausgebildet ist.

2. Magnetanordnung nach Anspruch 1, **dadurch gekennzeichnet, daß** die ersten und zweiten Windungen (8, 10) jeweils erste und zweite Windungsabschnitte (16 bzw. 18) umfassen, die in einer Umfangsrichtung des Abbildungsvolumen (2) senkrecht zur Achse (6) des Magnetfeldes ausgerichtet sind, und daß die ersten Windungsabschnitte (16) näher zum Abbildungsvolumen (2) angeordnet sind als die zweiten Windungsabschnitte (18).

3. Magnetanordnung nach Anspruch 2, **dadurch gekennzeichnet, daß** die ersten Windungsabschnitte (16) bogenförmig ausgebildet sind, wobei eine konkave Seite der ersten Windungsabschnitte (16) dem Abbildungsvolumen (2) zugewandt ist.

4. Magnetanordnung nach Anspruch 2 oder 3, **dadurch gekennzeichnet, daß** die zweiten Windungsabschnitte (18) bogenförmig ausgebildet sind, wobei eine konkave Seite der zweiten Windungsabschnitte (18) dem Abbildungsvolumen (18) zugewandt ist.

5. Magnetanordnung nach Anspruch 3 oder 4, **dadurch gekennzeichnet, daß** die Windungsabschnitte (16,18) kreisbogenförmig ausgebildet sind.

6. Magnetanordnung nach Anspruch 4 oder 5, **dadurch gekennzeichnet, daß** die ersten und zweiten Windungsabschnitte (16, 18) parallel zueinander verlaufen.

7. Magnetanordnung nach einem der Ansprüche 1 bis 6, **dadurch gekennzeichnet, daß** die Windungen (8, 10) kreisringsegmentförmig ausgebildet sind.

8. Magnetanordnung nach einem der Ansprüche 1 bis 7, **dadurch gekennzeichnet, daß** die ersten und zweiten Windungen (8,10) zu gegenüberliegend angeordneten ersten bzw. zweiten Spulenpaketen zusammengefaßt sind.

9. Magnetanordnung nach einem der Ansprüche 1 bis 8, **dadurch gekennzeichnet, daß** die ersten und zweiten Windungen in mehrere gegenüberliegend angeordnete erste bzw. zweite Spulen (8 bzw. 10) zusammengefaßt sind.

10. Magnetanordnung nach einem der Ansprüche 1 bis 9, **dadurch gekennzeichnet, daß** die Achse (6) des Magnetfeldes horizontal ausgerichtet ist.

11. Magnetanordnung nach Anspruch 9 oder 10, **dadurch gekennzeichnet, daß** die Windungsabschnitte (16,18) verschiedener Spulen (8.1,8.2,10.1,10.2) verschieden lang ausgebildet sind.

12. Magnetanordnung nach einem der Ansprüche 1 bis 11, **dadurch gekennzeichnet, daß** eine erste Anzahl Windungen (8,10,8.3,10.3) in senkrecht zur ersten Achse (6) des Magnetfeldes ausgerichteten Ebenen angeordnet ist.

13. Magnetanordnung nach einem der Ansprüche 1 bis 12, **dadurch gekennzeichnet, daß** eine zweite Anzahl von Windungen (8.4,10.4) auf schräg zur Achse (6) des Magnetfeldes ausgerichteten Flächen angeordnet ist.

14. Magnetanordnung nach einem der Ansprüche 1 bis 13, **dadurch gekennzeichnet, daß** an mindestens einer Stirnseite der ersten und zweiten Windungen (8, 10) mindestens eine kreisringförmige Spule (32,34) koaxial zur Achse (6) des Magnetfeldes angeordnet ist.

15. Magnetanordnung nach einem der Ansprüche 1 bis 13, **dadurch gekennzeichnet, daß** die ersten Windungen (8) mit den zweiten Windungen (10) über ein außerhalb des Abbildungsvolumens (2) angeordnetes C-förmiges Stativ (22) verbunden sind.

16. Magnetanordnung nach einem der Ansprüche 1 bis 12, **dadurch gekennzeichnet, daß** die ersten Windungen (8) mit den zweiten Windungen (10) über säulenartige Ständer (24) miteinander verbunden sind, die beidseits der Zugänge (12,14) angeordnet sind.

17. Magnetanordnung nach einem der Ansprüche 1 bis 14, **dadurch gekennzeichnet, daß** die ersten und zweiten Windungen (8,10) auf jeweils einem ferromagnetischen Träger gewickelt sind.

## Claims

1. Magnet arrangement for a diagnostic magnetic resonance instrument, having an electromagnet arrangement for generating a homogeneous magnetic field oriented along an axis (6) in an imaging volume (2), a transverse access (14) to the imaging volume (2) being formed in relation to the axis (6) of the magnetic field, **characterised in that** the electromagnet arrangement comprises first and second turns (8 and 10, respectively) arranged, opposite one another and at a distance from one another, crosswise to the axis (6) of the magnetic field, so that an axial access (12) to the imaging volume (2) is formed between the first and second turns (8, 10) in the direction of the axis (6) of the magnetic field.

2. Magnet arrangement according to Claim 1, **characterised in that** the first and second turns (8, 10) each comprise first and second turn sections (16 and 18, respectively), which are oriented in a circumferential direction of the imaging volume (2) perpendicular to the axis (6) of the magnetic field, and **in that** the first turn sections (16) are arranged closer to the imaging volume (2) than the second turn sections (18) are.

3. Magnet arrangement according to Claim 2, **characterised in that** the first turn sections (16) are designed with a curved shape, a concave side of the first turn sections (16) facing the imaging volume (2).

4. Magnet arrangement according to Claim 2 or 3, **characterised in that** the second turn sections (18) are designed with a curved shape, a concave side of the second turn sections (18) facing the imaging volume (18).

5. Magnet arrangement according to Claim 3 or 4, **characterised in that** the turn sections (16, 18) are designed with a circular arc shape.

6. Magnet arrangement according to Claim 4 or 5, **characterised in that** the first and second turn sections (16, 18) run parallel to one another.

7. Magnet arrangement according to one of Claims 1 to 6, **characterised in that** the turns (8, 10) are designed with a circular annular segment shape.

8. Magnet arrangement according to one of Claims 1 to 7, **characterised in that** the first and second turns (8, 10) are combined to form, respectively, first and second coil packets arranged opposite one another.

9. Magnet arrangement according to one of Claims 1 to 8, **characterised in that** the first and second turns are combined in a plurality of, respectively, first and second coils (8 and 10, respectively) arranged opposite one another.

10. Magnet arrangement according to one of Claims 1 to 9, **characterised in that** the axis (6) of the magnetic field is oriented horizontally.

11. Magnet arrangement according to Claim 9 or 10, **characterised in that** the turn sections (16, 18) of different coils (8.1, 8.2, 10.1, 10.2) are designed with different lengths.

12. Magnet arrangement according to one of Claims 1 to 11, **characterised in that** a first number of turns (8, 10, 8.3, 10.3) are arranged in planes oriented perpendicularly to the first axis (6) of the magnetic field.

13. Magnet arrangement according to one of Claims 1 to 12, **characterised in that** a second number of turns (8.4, 10.4) are arranged on surfaces oriented obliquely to the axis (6) of the magnetic field.

14. Magnet arrangement according to one of Claims 1 to 13, **characterised in that** at least one coil (32, 34) of circular annular shape is arranged, coaxially with the axis (6) of the magnetic field, on at least one end side of the first and second turns (8, 10).

15. Magnet arrangement according to one of Claims 1 to 13, **characterised in that** the first turns (8) are connected to the second turns (10) through a C-shaped stand (22) arranged outside the imaging volume (2).

16. Magnet arrangement according to one of Claims 1 to 12, **characterised in that** the first turns (8) and the second turns (10) are connected to one another through columnar frames (24), which are arranged on either side of the accesses (12, 14).

17. Magnet arrangement according to one of Claims 1 to 14, **characterised in that** the first and second turns (8, 10) are each wound on a respective ferromagnetic support.

## Revendications

1. Dispositif d'aimants pour un appareil de diagnostic par résonance magnétique, comprenant un dispositif à électroaimants de production, dans un volume (2) de reproduction, d'un champ magnétique homogène et dirigé le long d'un axe (6), un accès (14) au volume (2) de reproduction étant ménagé transversalement par rapport à l'axe (6) du champ magnétique, **caractérisé en ce que** le dispositif à électroaimants comprend des premières et secondes spires (8, 10) disposées transversalement à l'axe (6) du champ magnétique en étant à distance l'une en face de l'autre, de manière à former entre les premières et secondes spires (8, 10), un accès axial au volume (2) de reproduction, en direction de l'axe (6) du champ magnétique.

2. Dispositif d'aimants suivant la revendication 1, **caractérisé en ce que** les premières et secondes spires (8, 10) comprennent respectivement, des premiers et seconds tronçons (16 et 18) de spire, qui sont dirigés dans une direction de pourtour du volume (2) de reproduction perpendiculairement à l'axe (6) du champ magnétique, et **en ce que** les premiers tronçons (16) de spire sont plus près du volume (2) de reproduction que les seconds tronçons (18) de spire.

3. Dispositif d'aimants suivant la revendication 2, **caractérisé en ce que** les premiers tronçons (16) de spire sont en forme d'arcs, un côté concave des premiers tronçons (16) de spire étant tourné vers le volume (2) de reproduction.

4. Dispositif d'aimants suivant la revendication 2 ou 3, **caractérisé en ce que** les seconds tronçons (18) de spire sont en forme d'arcs, un côté concave des seconds tronçons (18) de spire étant tourné vers le volume (18) de reproduction.

5. Dispositif d'aimants suivant la revendication 3 ou 4, **caractérisé en ce que** les tronçons (16, 18) de spire sont en forme d'arcs de cercle.

6. Dispositif d'aimants suivant la revendication 4 ou 5, **caractérisé en ce que** les premiers et seconds tronçons (16, 18) de spire s'étendent parallèlement entre eux.

7. Dispositif d'aimants suivant l'une des revendications 1 à 6, **caractérisé en ce que** les spires (8, 10) sont en forme de segments d'anneau circulaire.

8. Dispositif d'aimants suivant l'une des revendications 1 à 7, **caractérisé en ce que** les premières et secondes spires (8, 10) sont rassemblées en des premier et deuxième paquets de bobines disposés de manière opposée.

9. Dispositif d'aimants suivant l'une des revendications 1 à 8, **caractérisé en ce que** les premières et secondes spires sont rassemblées entre plusieurs premières et secondes bobines (8 et 10) disposées de manière opposée.

10. Dispositif d'aimants suivant l'une des revendications 1 à 9, **caractérisé en ce que** l'axe (6) du champ magnétique est horizontal.

11. Dispositif d'aimants suivant la revendication 9 ou 10, **caractérisé en ce que** les tronçons (16, 18) de spire de diverses bobines (8.1, 8.2, 10.1, 10.2) ont des longueurs différentes.

12. Dispositif d'aimants suivant l'une des revendications 1 à 11, **caractérisé en ce qu'**un premier nombre de spires (8, 10, 8.3, 10.3) est disposé dans des plans perpendiculaires au premier axe (6) du champ magnétique.

13. Dispositif d'aimants suivant l'une des revendications 1 à 12, **caractérisé en ce qu'**un deuxième nombre de spires (8.1, 10.4) est disposé sur des surfaces inclinées par rapport à l'axe (6) du champ magnétique.

14. Dispositif d'aimants suivant l'une des revendications 1 à 13, **caractérisé en ce qu'**il est prévu coaxialement à l'axe (6) du champ magnétique sur au moins un côté frontal des premières et secondes spires (8, 10) au moins une bobine (32, 34) en forme d'anneau circulaire.

15. Dispositif d'aimants suivant l'une des revendications 1 à 13, **caractérisé en ce que** les premières spires (8) sont reliées aux secondes spires (10) par un statif (22) en forme de C disposé à l'extérieur du volume (2) de reproduction.

16. Dispositif d'aimants suivant l'une des revendications 1 à 12, **caractérisé en ce que** les premières spires (8) sont reliées aux secondes spires (10) par des montants (24) en forme de colonne qui sont disposés de part et d'autre des accès (12, 14).

17. Dispositif d'aimants suivant l'une des revendications 1 à 14, **caractérisé en ce que** les premières et secondes spires (8, 10) sont enroulées sur respectivement un support ferromagnétique.
